# EUROPEAN PATENT SPECIFICATION

(11) **EP 1 145 609 B1**
(45) Date of publication and mention of the grant of the patent: **28.07.2004**
(21) Application number: 99965125.0
(22) Date of filing: 07.12.1999
(51) Int. Cl.: H05K 7/06, G06K 19/077

(54) **IMPROVED METHOD FOR WIRE-SCRIBING FILAMENT CIRCUIT PATTERNS WITH PLANAR AND NON-PLANAR PORTIONS; IMPROVED WIRE-SCRIBED BOARDS AND SMART CARD MADE BY THIS METHOD**
VERBESSERTES VERFAHREN ZUR VERLEGUNG EINES DRAHTFÖRMIGEN LEITERS AUF EBENEN UND NICHT EBENEN FLÄCHEN, VERBESSERTE PLATTEN-VERBINDUNGSKARTEN MIT DARIN VERLEGTEN DRÄHTEN UND MIT DIESEM VERFAHREN HERGESTELLTE CHIPKARTE
PROCEDE AMELIORE POUR DECOUPER A L'AIDE DE FILS DES MOTIFS DE CIRCUITS DE CHAUFFAGE DOTES DE SECTIONS PLANES ET NON PLANES; CARTES RAINUREES AMELIOREES ET CARTE A PUCES OBTENUES SELON CE PROCEDE

(30) Priority: 14.12.1998 US 211511
(43) Date of publication of application: 17.10.2001
(73) Proprietor: Advanced Interconnection Technology, Inc., Islip, NY 11751 (US)
(72) Inventor: KEOGH, Raymond, S., Farmingdale, NY 11735 (US)
(74) Representative: McLeish, Nicholas Alistair Maxwell
(86) International application number: PCT/US1999/028795
(87) International publication number: WO 2000/036891

(56) References cited:
- EP-A- 0 080 756
- WO-A-95/26538
- WO-A-97/30418
- DE-A- 19 619 771
- US-A- 3 674 602
- US-A- 3 674 914
- US-A- 5 483 603

## Description

### FIELD OF THE INVENTION

The present invention relates to wire-scribed circuit boards and methods of their manufacture. More particularly the present invention related to an improved apparatus for and method of adhering conductive filaments onto dielectric substrates to form filament circuit patterns with both planar and non-planar portions and interconnection cards, smart cards or optical fiber circuit cards formed therefrom.

### BACKGROUND OF THE INVENTION

In the manufacture and assembly of electric and electronic units, wiring boards have long been used to interconnect electronic components. These "interconnection" boards or cards have an insulating substrate with a plurality of electronic components, which may be integrated circuit packages, or other types of electronic, electro-optical or optical components, mounted thereto and a pattern of conductive path segments connecting components to one another.

U.S. Patent Nos. 3,674,602 and 3,674,914, both dated July 4, 1972, describe one method of the manufacture of interconnection cards. According to these methods, a substrate is mounted on a vacuum table. Then a wire is scribed onto a surface of the substrate in a pre-selected planar circuit pattern using a wire dispensing and bonding head. This method is known as "wire-scribing."

An adhesive film laminated to the surface of the substrate secures the wire to the substrate. Energy emitted by the bonding head actuates the adhesive film as the wire contacts therewith, so that the wire bonds to the substrate.

Thermo-compression bonding joins filaments to surface mounted components during wire-scribing. At connecting points, electrical insulation, if any, is removed. Then, the wire is pushed against the surface of the component. Simultaneously, thermal energy fuses the wire onto the component.

However, during thermo-compression bonding, the stresses can be so severe, reaching up to up to 12 MPa where one wire overlays itself or another wire (a "crossover"), that the wire conductor ruptures. In fact, U.S. Patent No. 5,483,603, issued to Luke et al. and dated January 9, 1996, describes a system and method of automatic optical inspection of wire-scribed circuit boards to detect breakage. Similarly. the stress on fiber optic filaments during wire-scribing increases the possibility of breakage, and "microbending," a condition that causes attenuation of the transmitted signal through the optical fiber.

An identification card, as defined by the international Standards Organization (ISO) in ISO 7810 is "[a] card identifying its bearer and issuer which may carry data required as input for the intended use of the card and for transactions based thereon." Some identification cards include an integrated circuit and are known as "integrated circuit cards" or "Smart Cards." More generally, Smart Cards refer to any portable card-like device which includes one or more electronic components, i.e., active components such as integrated circuits, transistors and diodes. and passive components such as resistors, capacitors and inductors. The integrated circuits can be formed on an integrated circuit chip and/or printed circuit board or wire scribed board that is , in turn, attached to the Smart Card. Smart Cards can be used for a wide variety of application such as prepaid "debit" cards (e.g.. phone cards, transit passes, electronic purse), subscriber cards (e.g., bank ATM cards, credit cards, point-of-sale cards), loyalty scheme cards (e.g., frequent flier cards), security access and identification cards, health insurance and service cards (with optional protected memory). GSM (global system management for European cellular phones) cards and encryption/decryption cards. More generally, Smart Cards are a type of interconnection card.

Smart Cards are used with a reader/writer device that includes an external interface that is used to transmit information to or from the Smart Card. Contact-type Smart Cards have an integrated circuit ("IC") embedded in a central inner layer of plastic material that makes up the card in such a manner that the contact points of the IC, usually gold plated contact points, are exposed at one surface. There is no embedded loop of wire (antenna) in the Contact-type Smart Card. In use, this card is inserted into an external interface such that the contacts on the card actually touch contacts within the external interface, thus, permitting communication between the card and the external interface. In this way, for instance, value can be added to a card, or a fixed amount can be debited for a particular transaction.

"Contactless" Smart Cards have a loop of wire, connected to an IC, embedded completely within the plastic body of the card. When brought into close proximity with a read/write device, a radio frequency (RF) signal from the device induces a small current in the loop of wire, which acts as an antenna. This powers the IC switch, in turn, transmits its own signal back to the read/write device using the antenna. Thus, physical contact between the IC and the device (the external interface) is not required to establish a communications link.

A third type of Smart Card, called a "Combination" Smart Card, has been proposed to be utilized in either a "contact' or a "contactless" mode. The Combination Smart Card would have the features of the Contact and Contactless type Smart Cards. Similar to the Contact-type Smart Card, in the Combination-type Smart Card an IC would be embedded in the plastic body of the card so that its contacts are exposed at the surface of the card. And similar to the Contactless type Smart Card, the Combination Smart Card would have a loop of wire, i.e., an antenna, embedded completely within the plastic body of the card. However, in the Combination Smart Card, the IC would be electrically interconnected to the embedded antenna.

Smart Cards generally have one or more printed external layers or "skins" which protects the IC. The skins are laminated to the inner layer to protect the filament circuit pattern. However, lamination must produce Smart Cards with smooth and uniform exteriors, to a tolerance of microns. ISO standard 10536 requires that the maximum total thickness of contactless smart cards is 760 microns +/- 10%. Further, such high quality finished products may be subsequently printed with highly individualized information, such as digitized portraits.

Thus, a thin wire with a thin insulation coating is required for Smart Card applications. Because the filament circuit is embedded in the inner layer, the inner layer must be at least as thick as the outer diameter of the filament. The use of thin wires is required. Further, wire insulation must be removed before forming electrical connections between wires and electrical components, including semiconductor devices. Thin insulation coatings are required to ensure removal does not damage the thin wire.

Wires are generally provided with an insulating layer of dielectric material to avoid unwanted electrical connections between wires (a "short circuit"). However, insulation layers also increase the toughness of the wires and help avoid ruptures. Therefore. in wire-scribing applications, insulation coats advantageously elongate without rupture, even at stress levels up to 12 MPa.

In electrical systems, plastics and elastomers often function as electrical insulators. as structural reinforcement members, or frequently, a combination of these. A class of materials used in these applications is thermoplastics. These materials can be softened by heating and return to their original hardened condition when cool. Among common thermoplastic resins used as electric insulation are polyethylene, polystyrene, polyvinyl chloride, nylon, polytetrafluorethylene and polyimides. Other electrical insulation materials are thermosetting resins. Illustrative examples include rubber compounds, silicone rubber, neoprene, epoxy resins and polyurethanes. These materials do not soften under heating, which is advantageous in certain applications.

Polyimide insulation coated wires are often used for fabrication of wire-scribed circuit boards because of their good balance of mechanical and electrical properties. Polyimides may be formed by a polycondensation reaction of aromatic dianhydride with either aromatic diamine or aromatic diisocyanate. These materials greatly resistant thermal degradation, remaining thermally stable under vacuum to over 500°C. Dielectric properties range from 3.3 to 3.5 at 60 Hz. More importantly, wires with polyimide insulation are very tough. For example, a #38 American Wire Gauge (AWG) copper wire (0.1 mm diameter core) with a 0.023 mm thick polyimide insulation layer typically exhibits an ultimate tensile strength of about 545 grams, and an elongation of about 117% of its initial length before breakage occurs.

However, using polyimide insulation in the manufacture of wire-scribed circuit boards can be disadvantageous. Because polyimide coatings withstand temperatures as high as 900°F (482°C) , joining wires to components by thermo-compression bonding is difficult. The higher temperatures required often damage nearby electrical components.

A far better choice of insulating materials for wire-scribing is a polyurethane. Polyurethanes may be formed by reacting of one or more polyhydroxyl compounds (typically, glycols or sugars) with stoichiometric quantities of a difunctional isocyanate. Polyurethanes with a wide range of properties, spanning those of a soft elastomer to a rigid solid, may be made by adjusting the molecular weight and composition of the hydroxyl components. Polyurethane coatings have excellent film-mechanical properties, high hardness, and flexibility. Other advantageous features include low-temperature curing and adhesion to a variety of substrates. Dielectric properties range from 3.0 to 3.5 at 60 Hz. More importantly, polyurethane insulation coats are removable at normal soldering temperatures, such as between 600° to 650°F (315°C to 343°C).

However, polyurethane-coated wires are not tough. For example, a #38 AWG wire coated with a commercial grade polyurethane insulation layer (0.018 mm in thickness) typically has an ultimate tensile strength of about 263 grams and an elongation at break of 20% of its initial length. Commercial grade polyurethane-coated wire may rupture during manufacturing, particularly at crossovers where bonding forces may reach 12 mPA.

PCT publication number WO-A-95/26538 describes a procedure for producing a transponder unit provided with at least one chip and one coil, and in particular a chip card/chip-mounting board wherein the chip and the coil are mounted on one common substrate and the coil is formed by installing a coil wire and connecting the coil-wire ends to the contact surfaces of the chip on the substrate.

PCT publication number WO-A-97/30418 describes a process and device for the contacting of a wire conductor in the course of the manufacture of a transponder unit arranged on a substrate and comprising a wire coil and a chip unit, wherein in a first phase the wire conductor is guided away via the terminal area or a region accepting the terminal area and is fixed on the substrate relative to the terminal area or the region assigned to the terminal area, and in a second phase the connection of the wire conductor to the terminal area is effected by means of a connecting instrument.

### OBJECTS OF THE INVENTION

It is, therefore, an object of the present invention is to provide a method of making wire-scribed circuits that avoids filament breakage and the like by reducing the stress of the filaments during manufacture.

Another object of the present invention is to provide a method of making wire-scribed circuits without using thick, high performance insulation layers.

An additional object of the present invention is to provide a method of making wire-scribed circuits without using insulation layers that are difficult to remove.

A further object of the present invention is to provide wire-scribed circuits made with one or more crossovers that are essentially free of stresses.

Yet another object of the present invention is to provide wire-scribed circuit boards that do not require filaments, with thick, heavy polyimide insulation coatings to withstand the manufacturing process.

Yet still another object of the present invention is to provide wire-scribed circuit boards with filaments having thin polyurethane insulation coatings.

Still a further object of the present invention is to provide Smart Cards with smooth and uniform exteriors, such that subsequently they may be printed with, for example, digitized portraits.

These and other objects of this invention will be apparent to those skilled in the art upon reference to the following specification and claims.

### SUMMARY OF THE INVENTION

One aspect of the present invention provides a method of forming a filament circuit pattern according to claim 1. The present invention also provides a wire-scribed board according to claim 2 or claim 3. A further aspect of the present invention provides a Smart Card according to claim 4.

Additional features and advantages of the present invention will become apparent as the invention is more fully described in the following description, from the drawings, and from the claims. The description is purely illustrative and non-limiting.

### BRIEF DESCRIPTION OF THE DRAWINGS

FIG. 1 is a schematic of a device for manufacturing three-dimensional wire-scribed circuit boards.
FIG. 2A is a plan view of a portion of a wire-scribed circuit board, wherein a filament is attached to a substrate.
FIG. 2B is a plan view of the same portion of the wire-scribed circuit board shown in FIG. 2A, further showing the further bonding of the filament to the substrate during scribing of a filament circuit.
FIG. 2C is a plan view of the same portion of the wire-scribed circuit board shown in FIGS. 2A and 2B, further showing placement of a portion of the filament above previously scribed portions of the filament circuit.
FIG. 2D is a plan view of the same portion of the wire-scribed circuit board shown in FIGS. 2A - 2C, further showing the continuation of the bonding process after placing a portion of the filament above the majority of the filament circuit.
FIG. 2E is a plan view of the same portion of the wire-scribed circuit board shown in FIGS. 2A - 2D, further showing the continuation of the wire-scribing process.
FIG. 2F is a plan view showing a portion of the wire-scribed circuit board showing placement of a portion of the filament above a recess of the substrate.
FIG. 2G is a plan view showing a portion of the wire-scribed circuit board showing placement of a portion of the filament above a raised feature of the substrate.
FIG. 3A is a plan view of a portion of a wire-scribed circuit board, wherein a filament is attached to a substrate.
FIG. 3B is a plan view of the same portion of the wire-scribed circuit board shown in FIG. 3A, further showing the further bonding of the filament to the substrate during scribing of a filament circuit.
FIG. 3C is a plan view of the same portion of the wire-scribed circuit board shown in FIGS. 3A and 3B, further showing placement of a portion of the filament below previously scribed portions of the filament circuit.
FIG. 3D is a plan view of the same portion of the wire-scribed circuit board shown in FIGS. 3A - 3C, further showing the continuation of the bonding process while placing a portion of the filament below the majority of the filament circuit.
FIG. 3E is a plan view of the same portion of the wire-scribed circuit board shown in FIGS. 3A - 3D, further showing the continuation of the bonding process by resumption of scribing on the surface of the substrate.
FIG. 3F is a plan view of the same portion of the wire-scribed circuit board shown in FIGS. 3A - 3E, further showing the continuation of the bonding process by scribing additional portions of filament onto the embedded portion of filament
FIG. 4 is an overhead view of a crossover formed according to the present invention.

### DETAILED DESCRIPTION OF THE INVENTION

Interconnection cards, Smart Cards and optical fiber circuit cards have filament circuits scribed and adhered to an insulating substrate. A plurality of conductive filaments scribed form the filament circuit patterns. Each filament is continuously scribed and adhered to the substrate from one end of the filament to the other end, one filament after the other, until a complete filament circuit pattern has been wire-scribed. Electronic, electro-optical or optical components may be present on the surface of the substrate.

Any conductive filament may be used, including electrically and optically conductive filaments. For example, metallic conductive wire such as copper wire may be used. Insulation may be provided surrounding the filament.

Where a portion of filament is assigned to traverse another portion of filament (a "crossover"), insulation is required for metallic conductive filaments to avoid unwanted electrical connections. Insulation is optional for optical conductive filaments.

The adhesive coating and one or more underlying layer(s) of insulation, if present should be removable. Electrical connections between the scribed filament and components are made by removing the insulation and/or adhesive. Therefore, the adhesive coating and insulation layer(s) should be able to be removed without damaging the filament or the substrate surface to which the filament is bonded. Preferably, the insulation is a thermoplastic material that is readily removable at normal soldering temperatures.

The substrate forms a base of the interconnection card and provides structural strength and support. Any conventional substrate may be used. For example, the substrate can include: (1) a circuit substrate with or without etched foil power and ground conductors or the like. or (2) an electronic interconnection board, including a discrete-wired circuit board, a standard printed circuit board, a multilayer circuit board; a circuit board with components thereon, or a circuit board at any other stage of construction. The substrate may be made of any dielectric material including phenolic-paper laminates, epoxy-paper laminates, epoxy-glass laminates, epoxy-glass composite laminates. polyimide laminates, triazine resin laminates and other base materials having adequate thermal and electrical properties. The substrate material should have sufficient rigidity. strength and thickness to meet the requirements of the final interconnection board.

Wiring scribing requires that the substrate or the filament have an energy activateable adhesive surface. The filament or the substrate may be composed of a material with such properties. Alternately, the filament or the substrate may be provided with an adhesive coating. Wire scribing adhesives are well known in the art, and have been described in U.S. Patents Nos. 4,642,321 to Schonberg et al., 4,544,801 to Rudik et al. and 5,340,946 to Friedrich et al. An activateable adhesive coating may be applied to the substrate, such as a partially cured thermosetting resin which, when heated, becomes malleable and provides an adhesive bond when briefly heated. Alternately, the adhesive coating is provided to the filament.

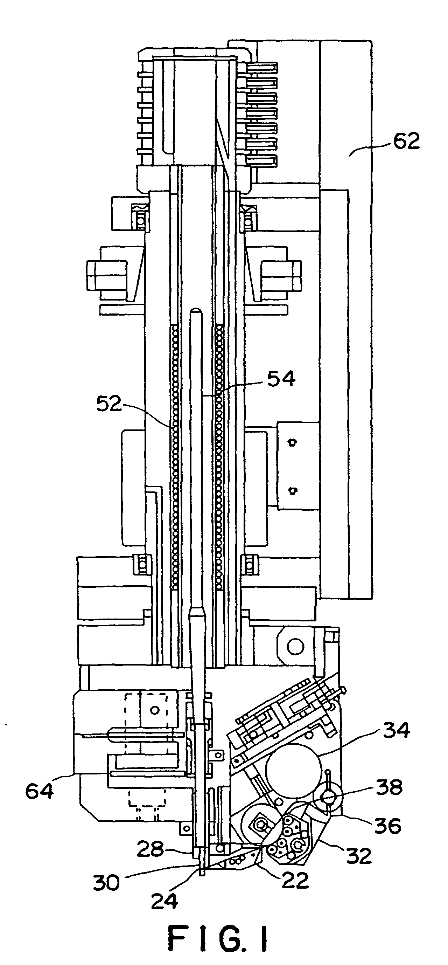

FIG. 1 depicts a schematic of an embodiment of an apparatus according to the present invention. An electromechanical wire feeding mechanism 32 is adapted to dispense a filament 102 towards a wiring head. The wire feeding mechanism 32 may consist of a feeder motor 34 coupled to a capstan or drive wheel 36. The capstan 36 is manufactured with a groove 26 made at close tolerance to the filament 102. Precision bearings 38 are situated to press the filament toward the wiring head 20. When the feeder motor 34 is actuated, the capstan 36 rotates and the filament 102 is forced to move into a filament guide 22 of the wiring head. Where the feeder motor 34 is a DC motor, the filament is fed at a velocity that is proportional to the DC voltage applied.

The wiring head has the aforementioned filament guide 22, as well as a stylus 24, and a bonding transducer. The filament guide 22 and stylus 24 are preferably manufactured with grooves formed at close tolerance to the outer diameter of the filament. The filament 102 passes from the wire feeding mechanism 32 to the filament guide 22, and is presented beneath the groove 26 of the stylus 24. The grooves of the stylus tip and the filament guide prevent any deviation of the filament position from true path. The transducer is positioned near the stylus tip 24 and applies energy to either the dispensed filament 102 or to the nearby substrate 106. The energy adheres at least the dispensed portion of the filament to the substrate.

The energy used to activate the adhesive surface should be controllable in magnitude and intensity. The level of the energy should activate the adhesive, but not damage the filament 102 or the substrate surface 106. Thermal, pressure, ultrasonic, laser or radiant energy sources or combinations thereof, may be used. For example, the adhesive may also be activated chemically using a solvent directed at a portion of the adhesive surface. Alternatively, heated or superheated gasses such as air may be directed at the coating to supply thermal energy to activate the adhesive.

FIG. 1 illustrates a preferred ultrasonic transducer assembly. The transducer assembly has a solenoid 52 that excites a magnetostrictive transducer 54 situated in the center of the solenoid 52 such that the transducer 54 mechanically oscillates at resonant frequency when current is applied to the solenoid 52. The mechanical motion of the transducer 54 is transmitted to a stylus tip 24 attached to the transducer 54 such that the tip 24 oscillates. The amplitude of the tip oscillation is proportional to the amplitude of the current applied to the solenoid 52. The tip 24 is rigidly supported by a bushing 28 or other support member such that deflection from true position is prevented.

Any conventional controller may be used to regulate the amount of energy applied to activate the adhesive surface.

An actuator assembly displaces the wiring head and the substrate 106 relative to one another along three orthogonal axes. Conventional motion platforms for this purpose are typically rotationally displaceable about their respective axes by hydraulic or pneumatic actuators. It will be understood, that either the substrate or the wiring head or both may be mounted on such motion platforms. Preferably, the substrate is fixed on to the motion platform capable of movement in only two directions (X and Y). The wiring head is moved along the (Z) axis. Thus, three axes (X, Y, Z) displacement of the wiring head relative to the substrate is possible. Any conventional means for three-dimensional movement ray be used.

Preferably, an actuator assembly moves the wiring head both laterally and vertically. More preferably, the actuator assembly displaces the stylus 24 and the filament guide 22 independently of one another. For example, when the adhesive is pressure sensitive, the actuator assembly preferably regulates the pressure exerted upon the filament by the stylus 24. An electronic or pneumatic system 62 positions the wiring head including the stylus tip 24 and controls pressure applied to clamp the filament against the substrate 106. In addition, a suspension assembly 64 may raise or lower the filament guide as required by the scribing process.

According to the above preferred embodiment, the stylus tip 24 initially rests at a roughly equal level to the filament guide 22. During the scribing process, the wire feeding mechanism 32 is actuated such that a section of filament is dispensed 102. The stylus tip 24 is lowered to press the filament 102 against the substrate 106. The filament guide 22 is positioned such that the filament 102 is trapped in the groove 26 of the stylus tip 24. The magnetostrictive transducer 54 is energized in order to apply energy to bond the filament 104 to the substrate 106.

The substrate 106 and filament guide 22 are then moved relative to one another in a pre-selected pattern. The wire feeder 32 and the filament guide 22 dispense a pre-determined amount of filament 102 onto the substrate to form a filament circuit. The transducer assembly is selectively actuated to bond the filament 104 to the substrate 106.

At termination points, a wire cutter 30 may be used to cut the filament.

At connection points, the transducer may be used to fuse the filament 104 to semiconductor devices 112 or other electrical or optical components.

When traversing a recessed feature such as a cavity 114, a raised feature such as a mounting pad or another wire 110, the sequence of events might work in the following fashion:

First, the controller reduces the energy applied to bond the filament 102 and the substrate 106. For example, the ultrasonic energy source is switched off or converted to an idling condition, and the pressure exerted by the stylus 24 to ensure intimate contact between the filament 102 and the substrate 106 is reduced. The wiring head is also raised a distance in the Z-direction away from the substrate 106.

Second, the head is driven to a fixed Z-axis height above the obstacle 108 or 110. As the head is moved up, DC current is applied to the feeder motor 34 to dispense filament 102, and the head then traverses the obstacle 108 or 110. In this manner, the amount of filament 102 dispensed and the displacement of the head 20 are controlled according to the dimension of the obstacle 108 or 110.

After traversing the obstacle 108 or 110. the head is lowered in the Z-axis direction toward the surface of the substrate 106 until the filament 102 contacts the substrate 106 and the stylus 26 exerts pressure thereon. The ultrasonic energy source is energized and the sequence continues as it has been previously described until the filament 104 is adhered and the filament circuit 100 is complete and the cutter is activated.

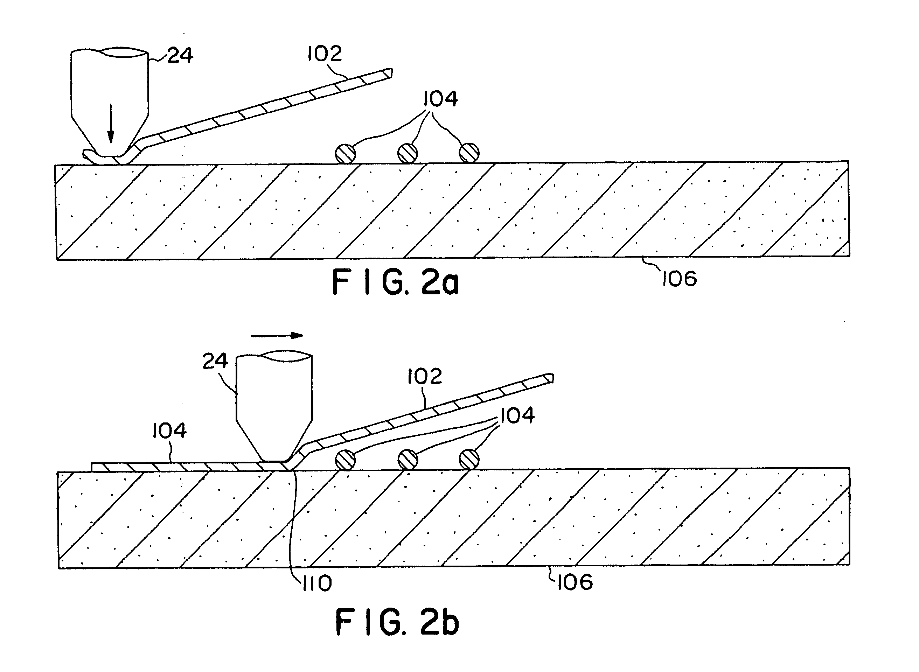

Referring now to FIGS. 2A-2G, in scribing filaments 102 onto the substrate 106 with the device 10 such as shown in Fig. 1, the substrate 106 is fixed to a worktable and associated with the wiring head. The movement of substrate 106 relative to the wiring head is preferably controlled by automated means. such as a computer. The wiring head may be stationary and the worktable movable in three directions. Alternately, the wiring head may be moveable in all three directions and the worktable stationary. The wiring head and the worktable may also both move in all three directions.

FIGS 2A - 2G illustrate the sequential steps used in creating an interconnection card with a filament circuit pattern having planar and non-planar portions. As depicted, the present invention allows filament circuit patterns 100 to be scribed while reducing the stress applied to the filament at crossovers. The present invention also allows filament circuit patterns to be scribed over pre-existing raised features 110 such as pads and contact patterns.

An interconnection card is shown in FIG. 2A in the initial steps of the wire-scribing process. The interconnection card includes a substrate 106 with filaments 104 adhered to the surface of the substrate 106. The substrate 106 may contain a number of recessed features 108, such as pre-drilled holes, slots, cavities or the like. Pads, contact patterns or other raised features 110 may also be provided on the surface of the substrate 106.

Once filaments 104 have been scribed and adhered to substrate 106, as described above, those portions of the substrate occupied by these filaments 104 are denoted as "first pre-assigned areas". Areas of the substrate containing or assigned to contain recessed or raised features 108 or 110 may also be denoted as first pre-assigned areas. While subsequent filaments may traverse the previously scribed filaments, such subsequently scribed filaments are not bonded directly to the substrate 106.

Referring to FIG. 2B. the scribing stylus 24 and the substrate 106 are moved relative to one another in an X-Y plane parallel to the surface of the substrate 106, while dispensing and adhering the filament 104 to the surface of the substrate 106. When the stylus 24 reaches a leading edge of a first pre-assigned area on the substrate 106 movement ceases. The stylus 24 is raised a distance in a Z-axis direction, perpendicular to the X-Y plane defined by the surface of the substrate. from the surface of the substrate 106.

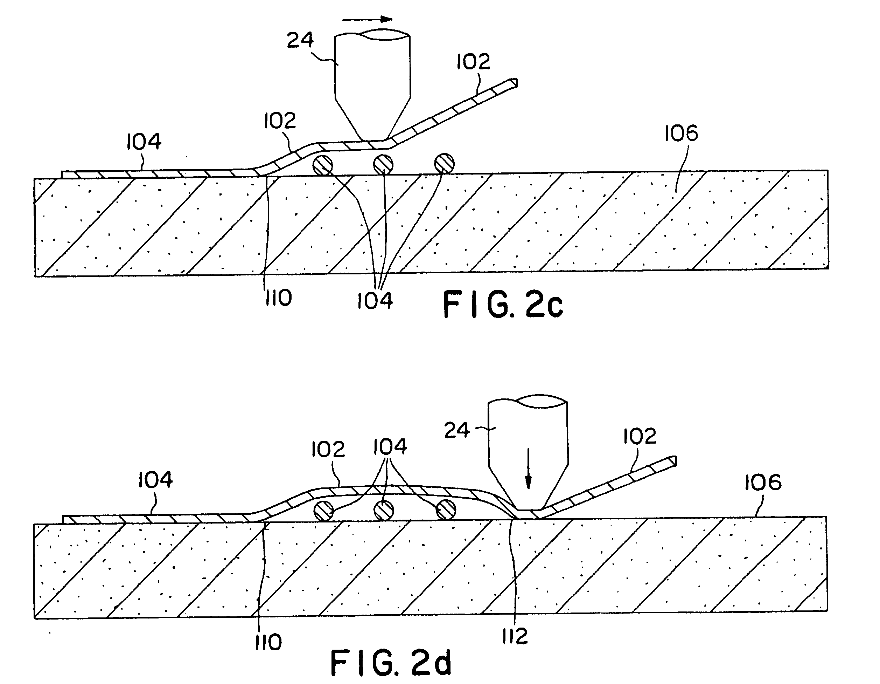

As shown in FIG. 2C, the stylus 24 and the substrate 106 are then moved relative to one another, while the filament 102 is dispensed. Activation energy to activate the adhesive is preferably not applied during this step. In this manner, subsequently scribed filaments 102 may traverse previously bonded filaments 104 without contacting then, and without be adhered to them.

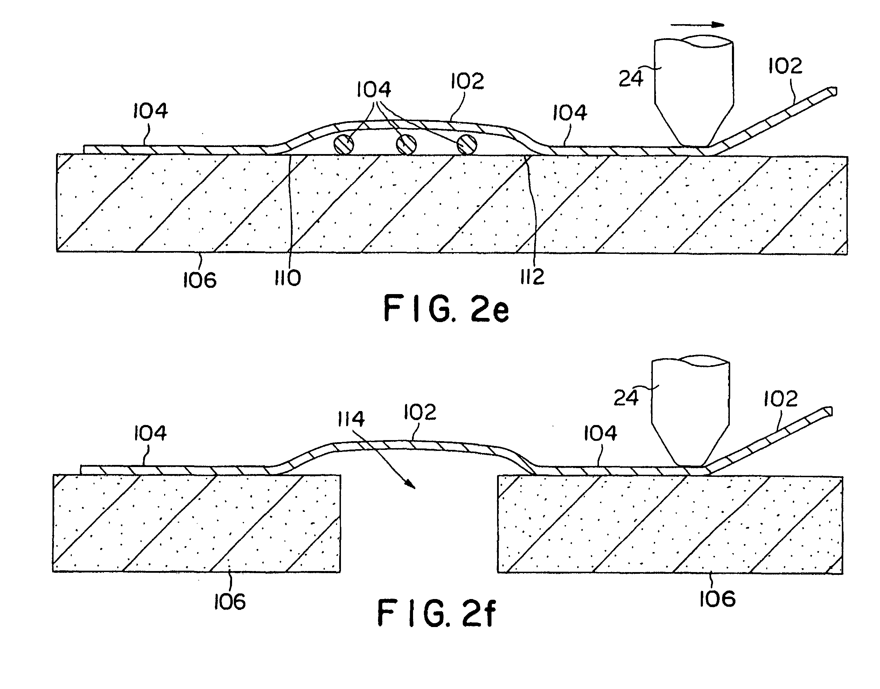

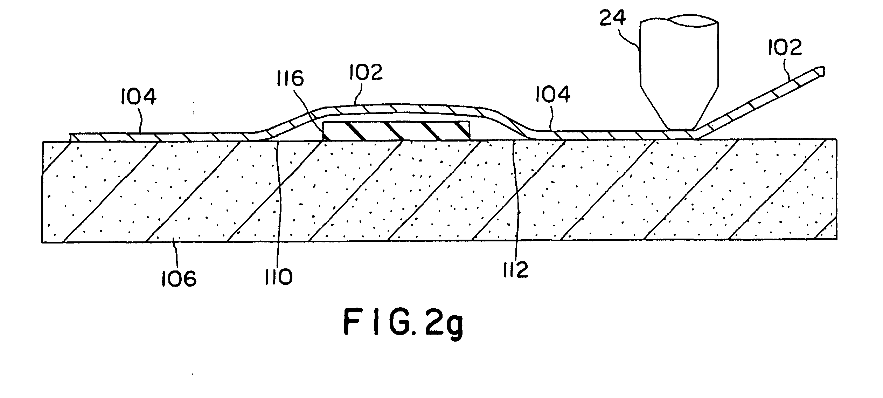

Referring to FIG. 2D. once the stylus 24 reaches a trailing edge of the first pre-assigned area on the substrate 106, the stylus 24 is again moved in a Z-axis direction to bring the filament 102 into contact with the surface of the substrate 106. The application of energy to activate the adhesive is resumed and the filament 104 is adhered to the surface of the substrate 106. As shown in Fig. 2E, the stylus 24 and the substrate 106 are moved relative to one another while the filament 104 is dispensed and adhered to the substrate surface 106. This process continues under a complete filament circuit pattern 100 is formed.

As shown in FIG. 2F, the procedure that is described above may be utilized to scribe an unbonded filament 102 over areas of the substrate 106, which contain a hole, a slot, a cavity or the like 114. FIG. 2G shows the same procedure utilized to scribe a filament 102 over an area of the substrate 106 with a raised feature 110, such as a pad or contact pattern.

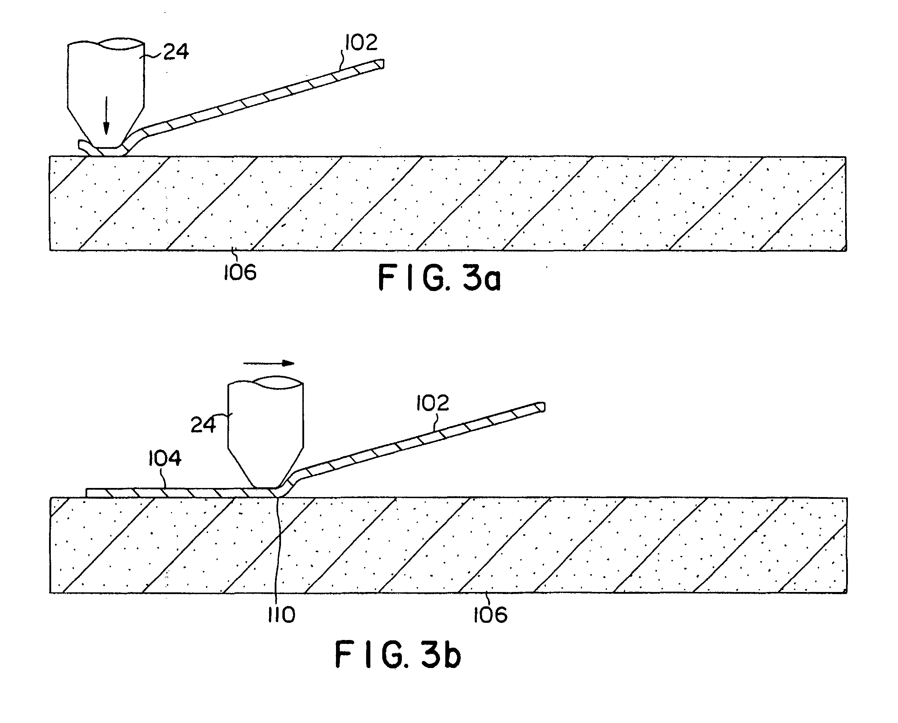

FIGS. 3A - 3F illustrate the sequential steps used in creating an interconnection card with non-planar portions of the filament circuit pattern comprises of lengths of filament 105 embedded into the substrate 106 a Z-axis direction below the X-Y plane defined by the substrate surface 106. As depicted, the present invention allows filament circuit patterns to be scribed while reducing the stress applied to the filament at crossovers. The present invention also allows filament circuit patterns into recessed features of the substrate 106.

An interconnection card 114 is shown in FIG. 3A in the initial steps of the wire-scribing process. A filament 102 is fed onto the substrate surface 106. The scribing stylus 24 is moved in the Z-axis direction toward the substrate surface 106 to bring the filament 102 and the substrate surface 106 into contact with one another. Simultaneously or subsequently, energy is applied to the filament 102 or the substrate or both to activate an adhesive surface. In this manner, the filament 104 is bonded to the substrate surface 106.

Referring to FIG. 3B, the scribing stylus 24 and the substrate 106 are moved relative to one another, while the filament 102 is dispensed onto the substrate surface 106. As the filament 102 contacts the substrate surface 106, it is adhered thereto, as described above.

Areas of the substrate 106 may be denoted as "second pre-assigned areas". These areas may include crossovers. At a leading edge of the second pre-assigned area on the substrate 106, movement of the stylus 24 and the substrate 106 relative to one another ceases. The stylus 24 and the substrate 106 are then moved closer to one another in the Z-axis.

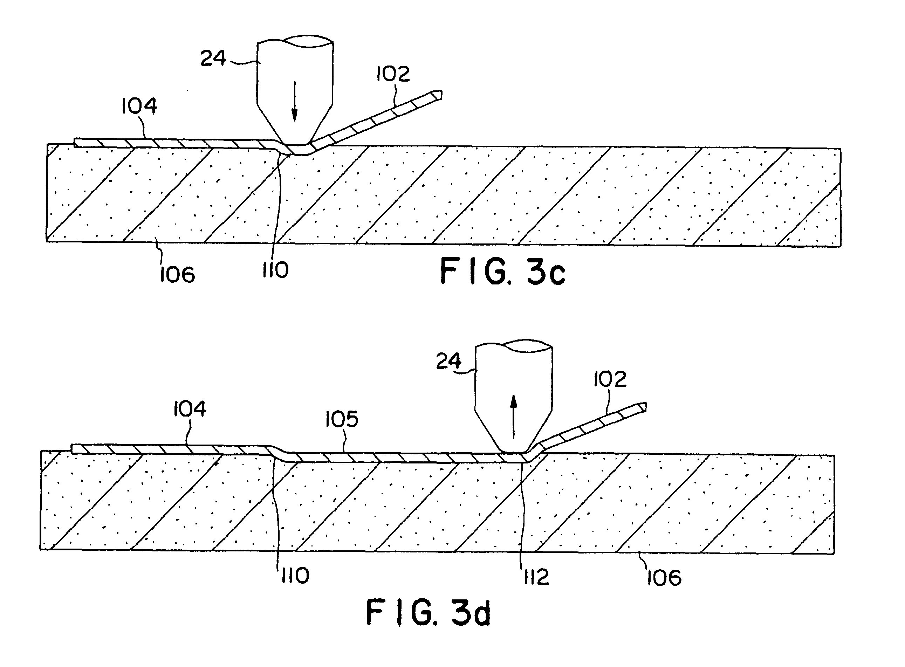

Referring to FIG. 3C, the stylus 24 is moved downward in a controlled and pre-selected manner in the Z-axis to embed the filament 105 below the surface of the substrate. The activation energy to activate the adhesive may be increased during this step. Then, the stylus 24 and the substrate 106 are moved relative to one another in the X and Y-axis directions.

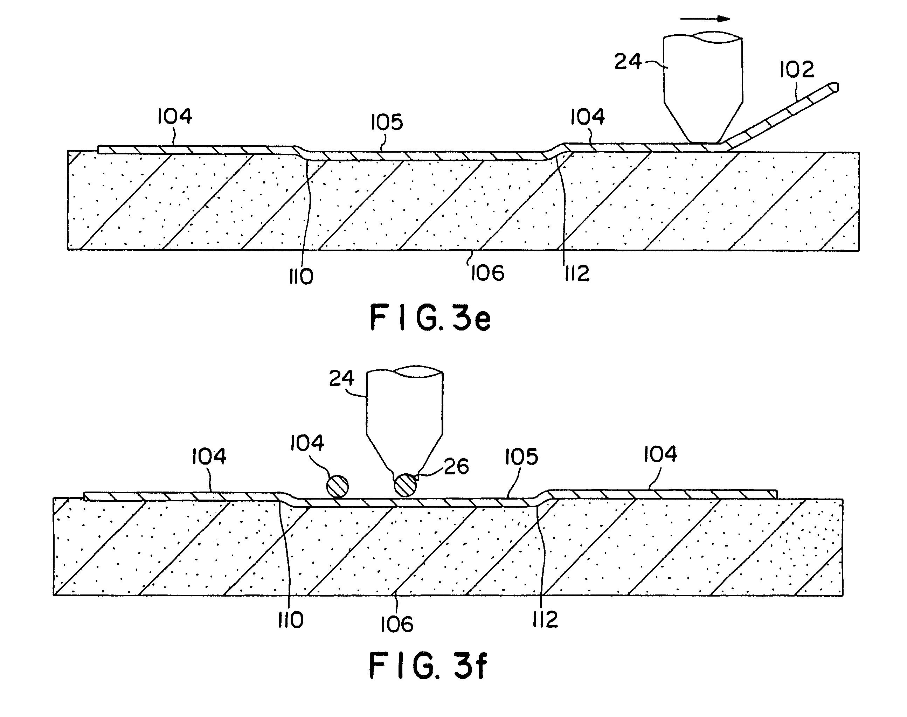

Referring to FIG. 3D, once the stylus 24 reaches a trailing edge of the second pre-assigned area on the substrate 106, the stylus 24 and the substrate 106 are moved relative to one another in the Z-axis direction to bring the filament 102 into contact with the substrate surface 106. The application of energy to activate the adhesive is resumed and the filament 104 is adhered to the substrate surface 106. As shown in FIG. 3E, the stylus 24 and the substrate 106 are moved relative to one another while the filament 104 is dispensed and adhered to the substrate surface. This process continues until a complete filament circuit pattern is formed.

As shown in FIG. 3F, a second filament 104 may be placed onto the embedded filaments 105, those filaments previously adhered in a second plane located below the substrate surface 106. At those points where the second filament 104 intersects with the embedded filament 105, not in accordance with the invention however, the application of energy to activate the adhesive surface is not terminated. Instead, the second filament 104 is adhered over top of the embedded filament 105. In this way, the second filament 104 remains in the same X-Y plane as the majority of the filament circuit pattern 100, crossing over embedded filaments 105.

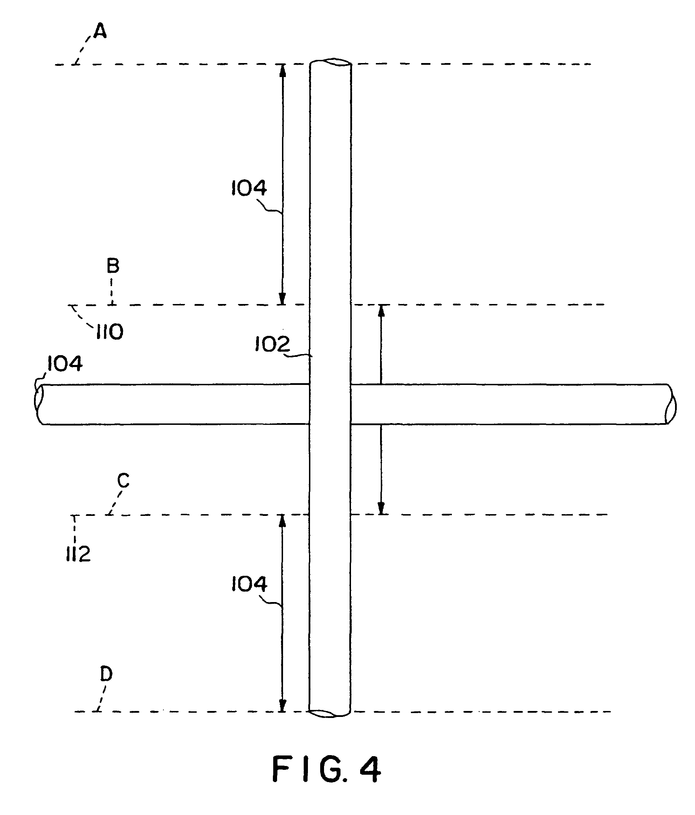

FIG. 4 is an overhead view of a crossover formed according to the present invention. A first wire 104 is bonded to the substrate surface as described above. A second wire 104 is similarly bonded in the same X-Y plane as the first wire from line A to line B. At line B, denoting a leading edge of a first pre-assigned area, the stylus 24 and substrate 106 are moved away from one another in the Z-axis direction. The stylus 24 is moved from line B to line C, denoting a trailing edge of the first pre-assigned area, and additional filament is dispensed 102. At line C, the stylus 24 and the substrate 106 are moved closer to one another in the Z-axis direction. Energy is applied to activate the adhesive and bond the filament 104 to the substrate surface 106. The stylus 24 and the substrate 106 are then moved relative to one another in the X-Y plane while the filament 104 is dispensed and adhered onto the surface of the substrate 106, as described above. Accordingly, a three-dimensional filament circuit is formed.

As illustrated and described above, the invention can be implemented by various embodiments. The invention, in its broader aspects. is not limited to the specific embodiments herein shown and described. Departures may be made therefrom within the scope of the accompanying claims without sacrificing its chief advantages.

## Claims

1. A method of forming a filament circuit pattern having planar and non-planar portions on or in the vicinity of a surface of a dielectric substrate (106), the method comprising:
(a) scribing a pre-selected length of a continuous conductive filament (102) in a plane parallel to the surface of the substrate (106) and on or in the vicinity of a surface of a substrate to form a planar portion of the circuit pattern from the scribed length of filament, the filament being fed through a filament guide (22), the filament guide being moveable in a Z-axis direction, the substrate (106) being moveable in an X-axis direction and a Y-axis direction, and wherein the Z-axis direction, the Y-axis direction and the X-axis direction are mutually orthogonal;
(b) forming a non-planar portion of the circuit pattern by placing a next pre-selected length of the continuous filament (102) that is contiguous to the immediately preceding scribed length so that the next pre-selected length of filament traverses but does not contact or adhere to a pre-selected surface or feature forming part of the surface of the substrate so as to keep the filament in the non-planar portion essentially free of stresses; and
(c) scribing in a plane parallel to the surface of the substrate, and on or in the vicinity of a surface of a substrate, a second next pre-selected length of the continuous filament (102) that is contiguous to the length of the filament that forms the non-planar portion of the filament circuit pattern to form another planar portion of the circuit pattern, and, during a transition between steps (a) and (b), or between steps (b) and (c), simultaneously moving the filament guide (22) in the Z-axis direction and the substrate (106) in both the Y-axis direction and the X-axis direction.

2. A wire-scribed board comprising:
a dielectric substrate (106); and
a continuous filament circuit pattern defined by a conductive filament (102), the pattern having a planar portion scribed on or in the vicinity of a surface of the substrate (106), and a non-planar portion scribed so that the filament traverses but does not contact or adhere to a pre-selected surface or feature forming part of the surface of the substrate so as to keep the filament in the non-planar portion essentially free of stresses.

3. A wire-scribed board comprising:
a dielectric substrate (106); and
a continuous filament circuit pattern defined by a conductive filament (102), the pattern having (1) a planar portion of a filament circuit pattern scribed in a plane parallel to the surface of the substrate, (2) a non-planar portion of the filament circuit pattern formed so that the filament of the non-planar portion is embedded below the surface of the substrate, and (3) another planar portion of the circuit pattern formed so that the filament traverses but does not contact or adhere to a pre-selected part of the previously scribed non-planar portion of the circuit pattern so as to keep the filament in the another planar portion essentially free of stresses.

4. A Smart Card comprising:
a dielectric substrate (106) having a top surface and a bottom surface;
a filament circuit pattern on or in the vicinity of the top surface of the substrate, the filament circuit pattern having a planar portion mounted in a plane parallel to the top surface of the substrate, and a non-planar portion formed on or in the vicinity of the top surface by placing the filament so that the filament traverses but does not contact or adhere to a pre-selected surface or feature forming part of the top surface so as to keep the filament in the non-planar portion essentially free of stresses;
an electronic component mounted on the substrate, the electronic component electrically coupled to the filament circuit pattern; and
a pair of external layers of dielectric material laminated to the top surface and the bottom surface of the substrate respectively, so that the filament circuit pattern is positioned between the pair of external layers.

## Patentansprüche

1. Verfahren zur Bildung eines Fadenleiter-Musters, welches ebene und nicht ebene Bereiche auf oder in der Nähe einer Oberfläche eines dielektrischen Trägers (106) aufweist, wobei das Verfahren umfasst:
a.) Ritzen einer vorgewählten Länge eines kontinuierlichen Fadens (102) in eine zur Oberfläche des Trägers (106) parallelen Ebene und auf oder in der Nähe einer Oberfläche eines Trägers, um einen ebenen Bereich des Leiter-Musters aus der geritzten Fadenlänge zu bilden, wobei der Faden durch eine Fadenführung zugeführt wird, die Fadenführung in Richtung der Z-Achse beweglich ist, der Träger (106) in Richtung der X-Achse und der Y-Achse beweglich ist und wobei die Z-Achsen-Richtung, die Y-Achsen-Richtung und die X-Achsen-Richtung gegenseitig orthogonal sind;
b.) Bilden eines nicht ebenen Bereichs des Leiter-Musters durch Anordnen einer nächsten vorgewählten Länge des kontinuierlichen Fadens (102), welche benachbart zur unmittelbar vorhergehenden geritzten Länge ist, so dass die nächste vorgewählte Fadenlänge eine vorgewählte Oberfläche oder eine Besonderheit, welche einen Teil der Oberfläche des Trägers bilden, überquert, aber nicht berührt oder anhaftet, so dass der Faden im nicht ebenen Bereich im Wesentlichen frei von Beanspruchungen gehalten ist.
c.) Ritzen in einer Ebene parallel zur Oberfläche des Trägers und auf oder in der Nähe einer Oberfläche eines Trägers einer zweiten vorgewählten Länge des kontinuierlichen Fadens (102), welche benachbart ist zur Fadenlänge, welche den nicht ebenen Bereich des Fadenleiter-Musters bildet, um einen anderen ebenen Bereich des Leitermusters zu bilden, und, während eines Übergangs zwischen den Schritten (a) und (b) oder zwischen den Schritten (b) und (c), gleichzeitiges Bewegen der Fadenführung (22) in Z-Achsen-Richtung und des Trägers sowohl in Y-Achsen-Richtung als auch in X-Achsen-Richtung.

2. Eine draht-geritzte Tafel umfassend:
einen dielektrischen Träger (106); und
ein durch einen leitenden Faden (102) definiertes kontinuierliches Fadenleiter-Muster, wobei das Muster einen auf oder in der Nähe einer Oberfläche des Trägers (106) geritzten ebenen Bereich aufweist und einen nicht ebenen, derart geritzten Bereich, dass der Faden eine vorgewählte Oberfläche oder eine Besonderheit, welche einen Teil der Oberfläche des Trägers bilden, überquert, aber nicht berührt oder anhaftet, so dass der Faden im nicht ebenen Bereich im Wesentlichen frei von Beanspruchungen gehalten ist.

3. Eine draht-geritzte Tafel, umfassend:
einen dielektrischen Träger (106); und
ein durch einen leitenden Faden (102) definiertes kontinuierliches Fadenleiter-Muster, wobei das Muster
(1) einen ebenen in eine Ebene parallel zur Oberfläche des Trägers geritzten Bereich des Fadenleiter-Musters aufweist,
(2) einen nicht ebenen Bereich des Fadenleiter-Musters, der so ausgebildet ist, dass der Faden des nicht ebenen Bereichs unterhalb der Oberfläche des Trägers eingebettet ist, und
(3) einen anderen ebenen Bereich des Leiter-Musters, der so ausgebildet ist, dass der Faden einen vorgewählten Teil des vorangehend geritzten nicht ebenen Bereichs des Leiter-Musters überquert, aber nicht berührt oder anhaftet, so dass der Faden im anderen ebenen Bereich im Wesentlichen frei von Beanspruchungen gehalten ist.

4. Chipkarte, umfassend:
einen dielektrischen Träger (106), welcher eine obere Oberfläche und eine untere Oberfläche aufweist;
ein Fadenleiter-Muster auf oder in der Nähe der oberen Oberfläche des Trägers, wobei das Fadenleiter-Muster einen in einer Ebene parallel zur oberen Oberfläche des Trägers angebrachten ebenen Bereich aufweist und einen auf oder in der Nähe der oberen Oberfläche gebildeten nicht ebenen Bereich durch Anordnen des Fadens so, dass der Faden eine vorgewählte Oberfläche oder eine Besonderheit, welche einen Teil der Oberfläche des Trägers bilden, überquert, aber nicht berührt oder anhaftet, so dass der Faden im nicht ebenen Bereich im Wesentlichen frei von Beanspruchungen gehalten ist;
eine elektronische Komponente, welche auf dem Träger angebracht ist, wobei die elektronische Komponente elektrisch mit dem Fadenleiter-Muster verbunden ist; und
ein Paar äußere Schichten von dielektrischem Material, welche jeweils auf die obere Oberfläche und die untere Oberfläche des Trägers geschichtet sind, so dass das Fadenleiter-Muster zwischen dem Paar äußerer Schichten angeordnet ist.

## Revendications

1. Procédé de formation d'un motif de circuit filamentaire ayant des sections planes et non planes sur ou à proximité d'une surface d'un substrat diélectrique (106), le procédé comprenant :
(a) la délimitation d'une longueur présélectionnée d'un filament conducteur continu (102) dans un plan parallèle à la surface du substrat (106) et sur ou à proximité d'une surface d'un substrat pour former une section plane du motif de circuit à partir de la longueur délimitée du filament, le filament étant acheminé à travers un guide-filament (22), le guide-filament étant mobile dans une direction d'axe Z, le substrat (106) étant mobile dans une direction d'axe X et une direction d'axe Y, et dans lequel la direction d'axe Z, la direction d'axe Y et la direction d'axe X sont mutuellement orthogonales ;
(b) la formation d'une section non plane du motif de circuit en plaçant une longueur présélectionnée suivante du filament continu (102) qui est contiguë à la longueur délimitée immédiatement précédente de sorte que la longueur présélectionnée suivante du filament traverse mais n'entre pas en contact avec ni n'adhère à une surface ou caractéristique présélectionnée formant une partie de la surface du substrat de façon à garder le filament dans une section non plane en grande partie exempte de tension ; et
(c) la délimitation dans un plan parallèle à la surface du substrat, et sur ou à proximité d'une surface d'un substrat, d'une deuxième longueur suivante présélectionnée du filament continu (102) qui est contiguë à la longueur du filament qui forme la section non plane du motif de circuit filamentaire pour former une autre section plane du motif de circuit et, pendant une transition entre les étapes (a) et (b), ou entre les étapes (b) et (c), le déplacement simultané du guide-filament (22) dans la direction d'axe Z et du substrat (106) à la fois dans la direction d'axe Y et la direction d'axe X.

2. Carte rainurée comprenant :
un substrat diélectrique (106) ; et
un motif continu de circuit filamentaire défini par un filament conducteur (102), le motif ayant une section plane délimitée sur ou à proximité d'une surface du substrat (106), et une section non plane délimitée de sorte que le filament traverse mais n'entre pas en contact avec ni n'adhère à une surface ou caractéristique présélectionnée formant une partie de la surface du substrat de façon à garder le filament dans la section non plane en grande partie exempte de tension.

3. Carte rainurée comprenant :
un substrat diélectrique (106) ; et
un motif de circuit filamentaire continu défini par un filament conducteur (102), le motif ayant (1) une section plane d'un motif de circuit filamentaire délimitée dans un plan parallèle à la surface du substrat, (2) une section non plane du motif de circuit filamentaire formée de sorte que le filament de la section non plane soit enfouie sous la surface du substrat, et (3) une autre section plane du motif de circuit formée de sorte que le filament traverse mais n'entre pas en contact avec ni n'adhère à la partie présélectionnée de la section non plane précédemment délimitée du motif de circuit de façon à garder le filament dans l'autre section plane en grande partie exempte de tension.

4. Carte à puce comprenant :
un substrat diélectrique (106) ayant une surface supérieure et une surface inférieure ;
un motif de circuit filamentaire sur ou à proximité de la surface supérieure du substrat, le motif de circuit filamentaire ayant une section plane montée dans un plan parallèle à la surface supérieure du substrat, et une section non plane formée sur ou à proximité de la surface supérieure en plaçant le filament de sorte que le filament traverse mais n'entre pas en contact avec ni n'adhère à une surface ou caractéristique présélectionnée formant une partie de la surface supérieure de façon à garder le filament dans la section non plane en grande partie exempte de tension ;
un composant électronique monté sur le substrat, le composant électronique étant électriquement couplé au motif de circuit filamentaire ; et
une paire de couches externes de matériau diélectrique stratifiées respectivement sur la surface supérieure et la surface inférieure du substrat, de sorte que le motif de circuit filamentaire soit positionné entre la paire de couches externes.
